# EUROPEAN PATENT APPLICATION

(11) **EP 0 531 085 A2**
(43) Date of publication of application: **10.03.1993**
(21) Application number: 92307913.1
(22) Date of filing: 01.09.1992
(51) Int. Cl.: C30B 25/02, C30B 29/04, C23C 16/26

(54) **Isotopic diamond coated products and their production**

(30) Priority: 03.09.1991 US 753568
(71) Applicant: GENERAL ELECTRIC COMPANY, Schenectady, NY 12345 (US)
(72) Inventor: Tiemann, Jerome Johnson, Schenectady, New York 12305 (US)
(74) Representative: Pratt, Richard Wilson

(57) **Abstract**

Broadly, the present invention is directed to a diamond product comprising a core of diamond containing at least about 1 wt-% ¹³C and an epitaxial diamond coating on said core containing at least 1 wt-% less ¹³C than is contained is said diamond core. The diamond core will have a lattice parameter that is smaller that the lattice parameter of the diamond coating. When the coating is forced to grow epitaxially so that it must have the same lattice constant as the diamond core, the coating will be placed under compression. Since ¹³C diamond has the smallest lattice parameter known and the lattice parameter of diamond is a function of isotopic composition, the diamond core should contain more ¹³C than is contained in the coating in order for the coating to be placed under compression. Accordingly, the diamond core can be composed of natural or synthetic diamond having a natural isotopic composition and the coating can be ¹²C or ¹³C. Alternatively, the core can be ¹³C and the coating ¹²C. When mixtures of isotopes comprise the core and/or coating, their composition should vary by at least 1 wt-% ¹³C with the higher incidence of ¹³C isotope being located in the core.

## Description

The present invention relates to the preparation of polycrystalline diamond and more particularly to polycrystalline diamond possessing enhanced thermal conductivity and hardness properties.

High thermal conductivity diamond, such as high quality selected type II natural diamond, is characterized by a very high degree of purity and is reported to have a thermal conductivity at 25°C (298°K) on the order of about 21 watt/cm°K. Such high thermal conductivity diamond is useful, for example, as a heat sink material, such as in the backing of semi-conductors. Despite its high costs, type II natural diamond has been employed as a heat sink material because it has the highest thermal conductivity of diamonds. Conventionally-produced high pressure/high temperature (HP/HT) synthetic high quality, low nitrogen type II diamonds can be produced with a similarly high thermal conductivity. For the most part, diamonds prepared by low-pressure chemical vapor deposition (CVD) processes are not single crystal diamond and have materially lower thermal conductivities, typically on the order of 12 watts/cm°K at about 300°K (hereinafter sometimes referred to as "room temperature conductivity").

Since diamond is usually an electrical insulator, *i.e.* electrically non-conducting, heat is conducted by phonons. Anything that shortens the phonon mean free path (*i.e.* lattice vibration modes) degrades thermal conductivity. In 98% of natural diamonds (type Ia), nitrogen impurities scatter phonons. This reduces the mean free phonon path and, thus, the thermal conductivity, to near 8 watts/cm°K. In polycrystalline diamond typical of that made by CVD processes, there are many defects, such as, for example, twins, grain boundaries, vacancies, and dislocations, that reduce the phonon mean free path. The thermal conductivity of CVD diamond is remarkable in one sense in that it is about 60% of the thermal conductivity of highly perfect diamond.

With respect to polycrystalline diamond (in film, compact, or other form), thermal conductivity is known to be affected by, for example, impurities, isotopic effects, and grain boundary scattering, to name just a few factors. In fact, grain boundary scattering has been believed to be dominant in the lower thermal conductivity of polycrystalline diamond compared to single crystal diamond.

Isotopically pure ¹²C and ¹³C have been reported to possess improved thermal conductivity compared to natural diamond whether such isotopically pure diamond is in single crystal or polycrystalline form. It would be commercially beneficial if the improved thermal properties of isotopically pure diamond could be used to enhance diamond (both natural and synthetic) of natural isotope distribution. It would be even more commercially beneficial if the hardness and other performance properties of diamond of natural isotope distribution could be enhanced along with the thermal properties.

### Broad Statement of the Invention

Broadly, the present invention is directed to a diamond product comprising a core of diamond containing at least about 1 wt-% ¹³C and an epitaxial diamond coating on said core containing at least 1 wt-% less ¹³C than is contained in said diamond core. The diamond core will have a lattice parameter that is smaller than the lattice parameter of the diamond coating. When the coating is forced to grow epitaxially so that it must have the same lattice constant as the diamond core, the coating will be placed under compression. Since ¹³C diamond has the smallest lattice parameter known and the lattice parameter of diamond is a function of isotopic composition, the diamond core should contain more ¹³C than is contained in the coating in order for the coating to be placed under compression.

Accordingly, the diamond core can be composed of natural or synthetic diamond having a natural isotopic composition and the coating can be enriched in ¹²C. Alternatively, the core can be enriched in ¹³C and the coating can be natural diamond or enriched in ¹²C. When mixtures of isotopes comprise the core and/or coating, their composition should vary by at least 1 wt-% ¹³C with the higher incidence of ¹³C isotope being located in the core.

In the production of the inventive diamond product of the present invention, the core can comprise diamond particles or it can comprise a polycrystalline compact in a variety of configurations. Additionally, the core can comprise a layer of chemical vapor deposition (CVD) diamond. The coating advantageously will be applied by chemical vapor deposition techniques in order for it to grow epitaxially on the diamond core for achieving the coating affixed to the core being placed under compression. In this regard, the core need not be entirely enveloped by the coating, so that the coating can be incomplete or partial and the novel diamond product with improved properties still has been achieved. In this regard, it will be appreciated that improved heat transfer on cutting edges subjected to extreme heat will result by use of the diamond product of the present invention. Improved hardness also should result when using the inventive product for cutting abrading, sawing, and wire formation (wire drawing die configuration), and like uses.

Advantages of the present invention, then, include the ability to form a diamond product having a surface film that will be more resistant to chipping. Another advantage is a thin film that can be isotopically pure diamond that will have a higher thermal conductivity than conventional diamond and, thus, be able to conduct heat away in more efficient fashion. Yet another advantage is a diamond product having an outer layer that is more resistant to the formation of microcraks due to the built-in compressive stress in the outer epitaxially grown layer. These and other advantages will be readily apparent to those skilled in the art based upon the disclosure contained herein.

### Detailed Description of the Invention

Isotopically pure ¹²C and ¹³C are reported in commonly-assigned application Serial No. 07/536,371, filed June 11, 1991, the disclosure of which is expressly incorporated herein by reference. As between isotopically pure ¹²C and ¹³C, it has been discovered that ¹³C has a smaller lattice parameter and higher elastic constant than that of diamond composed of ¹²C. In fact, the lattice parameter of diamond is a function of isotopic composition as follows:

| Isotopic Composition | Lattice Parameter (A) |
|---|---|
| 99.9% ¹²C | 3.56713 |
| 62% ¹²C | 3.56696 |
| 32% ¹²C | 3.56679 |
| 1% ¹²C | 3.56669 |

Hardness of the material is proportional to the bond energy per unit volume. Substitution of ¹³C for ¹²C does not affect the bond strengths since the chemical nature of the covalent bonds do not change, so the net result is that unit volume becomes smaller and the bond energy density increases. Consequently, ¹³C diamond will have higher bond energy density than any other diamond and, in fact, will have the highest atomic density of any known material. Thus, it is expected that ¹³C should be harder than natural diamond. Similarly, the tighter lattice constant also will produce a higher modulus for ¹³C diamond.

It also has been reported that single-crystal isotopically pure ¹²C and ¹³C have improved thermal conductivity. Unexpectedly, it also has been discovered that polycrystalline isotopically pure ¹²C and ¹³C possess substantially higher thermal conductivity than would have been expected due to grain boundary scattering and other factors. See commonly-assigned application USSN 727,016, filed July 8, 1991, the disclosure of which is expressly incorporated herein by reference.

With respect to the novel diamond product, due to its superior thermal properties, the isotopically-pure coating spreads heat faster so that heat generated at cutting edges containing diamond particles will have the heat spread out over a larger volume of diamond and conducted away with less total temperature rise. Additionally, since the coating is placed under compression, the diamond product of the present invention will be more resistant to chipping. Diamond compacts containing a compressive layer of diamond should wear out more slowly and tolerate higher feed rates than conventional diamond compacts due to the higher thermal conductivity and greater resistance to chipping as compared to conventional diamond compacts. In diamond drawing die construction, the built-in compressive stress in the outer expitaxially grown-layer will suppress the formation of microcracks and result in higher performance wire drawing dies.

Diamond abrasive particles having the compressive diamond layer will provide longer abrasive life in polishing applications for decorative stone masonry such as polished marble, granite, onyx, and the like. Additionally, polishing applications include precious and semi-precious stones including, for example, sapphire, topaz, citrine, opal, YAG, spinel, peridot, garnet, strontium titanate, agate, sodalite, lapis lazuli, jade, hematite, obsidian, amethyst, emerald, ruby, and rutile. Further, abrasive wheels for tool sharpening, particularly those used for sharpening tungsten carbide saws and bits, will have superior performance and life utilizing the inventive diamond product of the present invention. In diamond saw applications this is also true when the diamond saws containing the inventive diamond product will be used to cut boules of silicon, sapphire, GaAs, germanium, into wafers.

Further, the inventive product will provide superior performance and life in diamond scribes, such as are used to cut window glass and glass mirror, as well as those commonly used to scribe semi-conductor wafers. The inventive product also should provide superior performance and life in rock drilling operations, such as core drilling, oil well drilling, and pavement cutting. Grinding and polishing of lenses and prisms where the diamond is used primarily to shape and polish an optical surface will be improved utilizing the diamond product of the present invention. Finally, when polishing other diamond material, the inventive diamond product in grit form will wear away at a substantially lower rate and thus increase the removal rate and reduce costs in such operations. Finally, the inventive diamond product in particle form can be used as feed in a high pressure/high temperature operation for making polycrystalline diamond compacts. The foregoing are but a few of the uses and advantages that will be achieved utilizing the inventive diamond product of the present invention, as those skilled in the art will readily appreciate based on the disclosure contained herein.

In one form, the inventive diamond product has a core composed of diamond of naturally occurring isotopic composition (either natural or synthetic diamond) and a coating that consists essentially of isotopically-pure ¹²C. In another form, the core is composed of isotopically-pure ¹³C and the coating is composed of isotopically pure ¹²C. In this case, the diamond product additionally takes advantage of the core ¹³C diamond itself with its improved properties, as described above. Finally, the core and coating each can be composed of isotopic mixtures of ¹²C and ¹³C wherein the ¹³C content will be at least 1 wt-% higher than the ¹³C content of the core so that the lattice parameter of the core will be smaller than the lattice parameter of the coating. Advantageously, the difference in ¹³C content between the core and coating will be at least about 10% and preferably at least about 50%. Thin outer layers are preferred so that the coating does not place the core under stress sufficient to pull apart the core at its cleavage planes. Thus, the compressive forces exerted by the outer layer must be balanced against the force required to cleave the core at any of its cleavage planes. For this reason also, preferably, no cleavage planes are exposed at the surface of the diamond core.

With respect to the diamond core, the diamond core can be composed of diamond particles made either by high pressure/high temperature (HP/HT) techniques well known in the art or can be produced by chemical vapor deposition (CVD) techniques also well known in the art. Additionally, the core can be composed of a polycrystalline layer or compact produced either by high pressure or low pressure techniques. In this regard, the polycrystalline compact or layer can be shaped in a wide variety of forms including cylindrical and annular in the case of wire drawing dies. Further, the polycrystalline layer or compact can be in unsupported or supported form wherein the support comprises metal, another diamond layer of similar or different isotopic composition, a metal cemented carbide (*e.g.* tungsten carbide, preferably cobalt cemented), or any other support known in the art.

Regardless of the shape of the core or whether in particulate or polycrystalline form, a coating is applied to at least a portion of the surfaces of the diamond wherein the layer is isotopically grown. As noted above, the epitaxial nature of the coating forces it to have the same lattice parameter as the core. Since the coating has an inherently larger lattice parameter than that of the core, the coating will be placed under compression. Formation of the epitaxial coating layer containing less ¹³C than the core preferably is by chemical vapor deposition techniques.

With respect to conventional CVD processes useful in the present invention, hydrocarbon/hydrogen gaseous mixtures are fed into a CVD reactor as an initial step. Hydrocarbon sources can include the methane series, *e.g.* methane, ethane, propane; unsaturated hydrocarbons, *e.g.* ethylene, acetylene, cyclohexene, and benzene; and the like. Methane, however, is preferred. Use of either carbon-12, carbon-13 or a mixture as above described for these hydrocarbon sources is made in accordance with the precepts of the present invention. The molar ratio of hydrocarbon to hydrogen broadly ranges from about 1;10 to about 1:1,000 with about 1:100 being preferred. This gaseous mixture optionally may be diluted with an inert gas, *e.g.* argon. The gaseous mixture is at least partially decomposed thermally by one of several techniques known in the art. One of these techniques involves the use of a hot filament which normally is formed of tungsten, molybdenum, tantalum, or alloys thereof. U.S. Pat. No. 4,707,384 illustrates this process.

The gaseous mixture partial decomposition also can be conducted with the assistance of d.c. discharge or radio frequency electromagnetic radiation to generate a plasma, such as proposed in U.S. Pats. Nos. 4,749,587, 4,767,608, and 4,830,702; and U.S. Pat. No. 4,434,188 with respect to use of microwaves. The substrate may be bombarded with electrons during the CVD decomposition process in accordance with U.S. Pat. No. 4,740,263.

Regardless of the particular method used in generating the partially decomposed gaseous mixture, the diamond core is maintained at an elevated CVD diamond-forming temperature which typically ranges from about 500° to 1100° C and preferably in the range of about 850° to 950° C where diamond growth is at its highest rate in order to minimize grain size. Pressures in the range of from about 0.01 to 1000 Torr, advantageously about 100-800 Torr, are taught in the art, with reduced pressure being preferred. Details on CVD processes additionally can be reviewed by reference to Angus, *et al.*, "Low-Pressure, Metastable Growth of Diamond and 'Diamondlike' Phases", *Science*, Vol. 241, pages 913-921 (August 19, 1988); and Bachmann, *et al*., "Diamond Thin Films", *Chemical and Engineering News,* pages 24-39 (May 15, 1989). The disclosures of all citations herein are expressly incorporated herein by reference.

As noted above, the diamond core can be grown by CVD techniques, or can be grown by high pressure/high temperature (HP/HT) techniques including growing the polycrystalline diamond directly, or growing the polycrystalline diamond and then sintering the diamond to form an appropriate piece. Though HP/HT techniques are well known in the art, reference to the following patents provides details on such processing conditions: U.S. Pats. Nos. 3,141,746; 3,381,428; 3,609,818; 3,745,623; 3,831,428; and 3,850,591, the disclosures of which are expressly incorporated herein by reference.

## Claims

1. A diamond product comprising a core of diamond containing at least about 1 wt-% ¹³C and an epitaxial diamond coating on said core containing at least 1 wt-% less ¹³C than is contained in said diamond core.

2. A method for making a diamond product which comprises epitaxially growing a diamond coating on a core of diamond where said diamond coating contains at least about 1 wt-% less ¹³C diamond than is contained in said diamond core.

3. The diamond product of Claim 1 or method according to Claim 2 wherein said core comprises diamond of natural isotopic composition and said coating is selected from isotopically-pure ¹²C diamond or ¹³C diamond.

4. The diamond product or method according to any preceding claim wherein said core is ¹³C diamond and said coating is ¹²C diamond.

5. The diamond product or method according to any preceding claim wherein said core comprises a polycrystalline layer or polycrystalline compact.

6. The diamond product or method according to any preceding claim wherein said core is annular.

7. The diamond product or method according to any preceding claim wherein said annular core is supported by a metal carbide annulus.

8. The diamond product or method according to any preceding claim wherein said coating contains at least about 10 wt-% less ¹³C diamond than is contained in said core.

9. The diamond product or method according to any preceding claim wherein said coating covers only a portion of said core.

10. The diamond product of method according to any preceding claim wherein said core is completely enveloped by said coating.
